(19) Europäisches Patentamt / European Patent Office / Office européen des brevets

(11) **EP 4 622 439 A1**

(12) **DEMANDE DE BREVET EUROPEEN**

(43) Date de publication:
**24.09.2025 Bulletin 2025/39**

(21) Numéro de dépôt: **25165139.4**

(22) Date de dépôt: **20.03.2025**

(51) Classification Internationale des Brevets (IPC):
**H10N 60/10** (2023.01)   **H01L 23/34** (2006.01)
**H10N 69/00** (2023.01)   **H10D 30/40** (2025.01)
**H10D 48/00** (2025.01)

(52) Classification Coopérative des Brevets (CPC):
**H10N 60/10; H10D 30/402; H10D 48/383;**
**H10N 69/00;** H01L 23/34

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **22.03.2024 FR 2402908**

(71) Demandeur: **Commissariat à l'Energie Atomique et aux Energies Alternatives
75015 Paris (FR)**

(72) Inventeurs:
• **BON MARDION, Charles**
  **38054 GRENOBLE Cedex 09 (FR)**
• **THOMAS, Candice**
  **38054 GRENOBLE Cedex 09 (FR)**
• **BERTRAND, Benoît**
  **38054 GRENOBLE Cedex 09 (FR)**
• **JADOT, Baptiste**
  **38054 GRENOBLE Cedex 09 (FR)**

(74) Mandataire: **Brevalex
Tour Trinity
1 B Place de la Défense
92400 Courbevoie (FR)**

(54) **STRUCTURE DE REFROIDISSEMENT INTEGREE POUR DISPOSITIF QUANTIQUE A QUBITS SEMI-CONDUCTEURS**

(57) Structure (150) pour refroidir un composant ($C_1$) d'un dispositif quantique en faisant circuler un courant donné entre un premier élément (51) de contact avec le composant et un deuxième élément (52) de contact avec le composant, le premier élément (51) de contact comprenant au moins un matériau métallique supraconducteur donné, en particulier à une température donnée inférieure à 2K, et étant en contact par une première extrémité avec une première portion semiconductrice dudit composant ($C_1$) de sorte à former avec la première portion semi-conductrice au moins une jonction tunnel de refroidissement.

FIG. 1

EP 4 622 439 A1

**Description**

**DOMAINE TECHNIQUE ET ETAT DE LA TECHNIQUE ANTERIEUR**

La présente demande se rapporte au domaine des dispositifs électroniques quantiques, en particulier ceux dotés de qubits formés dans une région semi-conductrice, et a trait à une structure intégrée améliorée pour refroidir un tel type de dispositif ainsi qu'à un procédé de fabrication. Les dispositifs quantiques s'appuient sur des qubits (parfois également notés « Qbits ») ou bit quantiques comme vecteurs d'informations, c'est-à-dire des bits d'informations basés sur un état quantique donné parmi au moins deux niveaux mesurables. Les qubits peuvent être formés dans un matériau semiconducteur au sein de structures de confinement de tailles nanométriques et contrôlées de manière électrostatique. Ces structures de confinement sont typiquement appelées « boites quantiques » (« quantum dots » en anglais). Une boîte quantique se comporte comme un puits de potentiel confinant une ou plusieurs charges élémentaires (électrons ou trous) dans une région de semiconducteur. Un type particulier de qubit semiconducteur est le qubit de spin lorsqu'on utilise le degré de liberté du spin d'électrons ou de trous pour coder l'information quantique. Pour mesurer l'état d'un qubit de spin, il est connu en particulier de procéder à une conversion spin/charge qui permet de convertir l'état de spin des particules chargées en un état de charge des boites quantiques contenant lesdites particules. Il est alors nécessaire de mesurer cet état de charge afin d'en déduire l'état de spin des particules chargées avant conversion. Pour cela, un moyen de mesure de l'état de charge est en général disposé à proximité de chaque boite quantique.

La lecture d'un qubit peut être notamment réalisée en utilisant une autre boîte quantique appelée « ilot de lecture » ou « ilot de détection » couplée à celle du qubit destiné à être lu. Ces deux éléments forment deux puits de potentiel séparés par une barrière de potentiel. De tels dispositifs fonctionnent généralement à une température très basse c'est à dire typiquement de l'ordre du Kelvin ou de quelques centaines de milli-Kelvins, pour éviter que le bruit thermique ne détruise la cohérence quantique. Par rapport au domaine des qubits supraconducteurs où la gamme de température est limitée à quelques dizaines de milli-Kelvins, le fonctionnement de qubits de spin a déjà été démontré à 1.5 K, offrant d'autres perspectives pour leur refroidissement. Les qubits sont refroidis en plaçant le dispositif dans un système réfrigérant ou cryostat pouvant atteindre des températures de l'ordre de la dizaine de milli-Kelvins.

Toutefois, on cherche également à améliorer la gestion thermique au sein du dispositif lui-même, par exemple entre des composants destinés à conserver l'information quantique, pour lesquels la température de fonctionnement est critique, mais présentant typiquement une faible dissipation thermique, et des composants de contrôle associés sous forme par exemple d'un circuit de lecture réalisé en technologie CMOS, pour lesquels la température de fonctionnement est moins critique, mais présentant typiquement une forte dissipation thermique.

Pour une co-intégration de ces éléments, une température de fonctionnement de 1 K peut être privilégiée afin d'augmenter la puissance de refroidissement disponible du cryostat pour la thermalisation du système.

Le document FR3°114°443 présente une solution consistant à prévoir dans une zone des pistes de routage conductrices assurant une fonction de conducteur thermique et électrique, et des pistes de routage supraconductrices assurant une fonction de conducteur électrique et d'isolant thermique. Cela permet d'améliorer la thermalisation à l'échelle du système tout en assurant une bonne isolation thermique entre les composants quantiques ou à qubits et les composants de contrôle.

Dans un autre domaine, celui de qubits supraconducteurs (qui code l'information quantique sur des résonateurs anharmoniques réalisés à partir de jonctions Josephson) les documents US2022/0138609, WO2023/156701A1 et US11302857B2 proposent un procédé de refroidissement à l'échelle des qubits supraconducteurs au moyen d'une jonction tunnel de refroidissement déportée et à distance des qubits

Il se pose le problème d'améliorer la gestion thermique d'un dispositif quantique à qubits semiconducteurs, en particulier à l'échelle des qubits, tout en limitant l'encombrement nécessaire à cette gestion.

**EXPOSÉ DE L'INVENTION**

C'est par conséquent un but de la présente invention d'offrir une structure de refroidissement pour dispositif quantique à qubits semiconducteurs et qui soit intégrée au sein ou au plus proche des composants quantiques ou de contrôle à refroidir.

Pour ce faire, selon un mode de réalisation, la présente invention prévoit un dispositif électronique quantique, en particulier à qubits de spin, comprenant un substrat et un composant disposé sur le substrat, le composant comportant au moins une zone dite « de canal » formée dans au moins une couche semiconductrice et comportant un ou plusieurs ilots, chaque ilot étant contrôlé par le biais d'une grille de contrôle électrostatique et formant une boite quantique ou un ilot de détection pour lire l'état quantique d'une boite quantique, le dispositif comprenant en outre : une structure prévue pour refroidir le composant en faisant circuler un courant donné entre un premier élément de contact avec le composant et un deuxième élément de contact avec le composant, le premier élément de contact comprenant au moins un matériau métallique supraconducteur donné, le premier élément de contact étant en contact par une première extrémité avec une première portion semiconductrice du composant de sorte à former avec la première portion semiconductrice au moins une jonction tunnel.

Cette jonction tunnel, également appelée jonction « de refroidissement » est en particulier de type NS (pour « Normal » « Supraconducteur ») ou NIS (pour « Normal » « Isolant » « Supraconducteur »).

On réalise ainsi un refroidissement du composant au plus près de la ou les couches semiconductrices dans laquelle ou dans lesquelles les qubits sont prévus, tout en n'impactant pas l'encombrement ce qui est essentiel pour le passage à l'échelle des dispositifs quantiques. Cette solution intégrée de refroidissement local permet notamment d'améliorer la stabilité des opérations quantiques, en protégeant de la chaleur dissipée par les composants de contrôle intégrés à proximité de façon monolithique ou par des techniques d'intégration 3D.

Outre l'aspect compact d'une telle structure de refroidissement et la possibilité de refroidir au plus près des qubits, une telle structure présente pour avantage de pouvoir être intégrée sans que cela ne nécessite un nombre d'étapes additionnelles et/ou d'adaptations importantes du procédé de fabrication. Le choix des matériaux utilisés permet d'obtenir une telle jonction tunnel dans le composant quantique et/ou le composant de contrôle.

Selon un mode de réalisation avantageux, le matériau métallique supraconducteur donné peut être un matériau ayant une température critique Tc supérieure à 2 K, avantageusement supérieure à 4 K, tel que du TiN.

Avantageusement, le premier élément de contact peut être, de la première extrémité jusqu'à une deuxième extrémité, formé du matériau métallique supraconducteur donné.

En variante, le premier élément de contact comporte au niveau de la première extrémité un empilement d'une zone diélectrique en contact avec la première portion semiconductrice et un tronçon à base du matériau métallique supraconducteur donné.

Avantageusement, cette zone diélectrique peut être une zone oxydée du matériau semiconducteur de la première portion semi-conductrice.

Selon une configuration particulière, le premier élément de contact peut comporter, au niveau la première extrémité, un empilement du matériau supraconducteur donné et d'un deuxième matériau supraconducteur ayant un gap plus élevé que le matériau supraconducteur donné, le deuxième matériau supraconducteur de gap plus élevé étant en contact avec la première portion semiconductrice.

Une telle configuration permet d'éviter que des électrons chauds ne reviennent vers la portion semi-conductrice et permet d'augmenter par conséquent les performances du refroidissement.

Selon un mode de réalisation dans lequel la zone de canal s'étend dans une première direction parallèle ou sensiblement parallèle à un plan principal du substrat et dans lequel le premier élément s'étend dans une direction orthogonale ou sensiblement orthogonale à la première direction, le premier élément de contact peut être relié par une deuxième extrémité à une piste métallique de matériau métallique supraconducteur parallèle ou sensiblement parallèle au plan principal du substrat.

Avantageusement, le premier élément de contact peut être formé d'un ensemble de plots contacts reliés en parallèle à la piste métallique.

Mettre plusieurs contacts en parallèle peut permettre de diminuer la résistance de la barrière isolante et d'augmenter la puissance de refroidissement.

Selon une mise en œuvre avantageuse, le deuxième élément de contact peut comprendre au moins un matériau métallique supraconducteur et être en contact avec une deuxième portion semiconductrice du composant de sorte à former avec la deuxième portion semiconductrice au moins une deuxième jonction tunnel NS ou NIS. Une configuration dans laquelle la jonction NS ou NIS est mise en série avec la deuxième jonction et où l'on fait circuler un courant de refroidissement à travers les deux jonctions peut être ainsi avantageusement prévue. Cette configuration est d'autant plus efficace que l'on met également en œuvre une symétrisation des jonctions par rapport à la zone N. Autrement dit on prévoit de préférence des zones supraconductrices « S » et le cas échéant des zones isolantes « I » identiques entre la jonction et la deuxième jonction.

Selon une possibilité de mis en œuvre, le deuxième élément de contact est en contact avec une deuxième portion semi-conductrice du composant et la zone de canal s'étend entre une région semi-conductrice dite « de source » et une deuxième région semiconductrice dite « de drain », la première portion semiconductrice et la deuxième portion semi-conductrice étant chacune des portions de la région de source ou de la région de drain.

Avantageusement, la structure pour refroidir le composant comprend en outre un troisième élément de contact en contact avec une troisième portion semiconductrice du composant et un quatrième élément de contact en contact avec une quatrième portion semiconductrice du composant, le troisième élément de contact formant une jonction tunnel, en particulier de type NIS ou NS avec la troisième portion semiconductrice du composant, la troisième portion semiconductrice et la quatrième portion semiconductrice étant chacune des portions d'une grille de contrôle électrostatique du composant.

Le deuxième élément de contact peut être en contact avec une deuxième portion semiconductrice du composant tandis que la première portion semiconductrice et la deuxième portion semi-conductrice sont chacune des portions d'une grille de contrôle électrostatique.

Selon une mise en œuvre possible, le deuxième élément de contact est en contact avec une deuxième portion semiconductrice du composant et la zone « de canal » comporte un ou plusieurs ilots de détection pour lire l'état quantique d'une ou plusieurs boites quantiques d'une autre partie du composant ou d'un autre composant et dans lequel la zone de canal s'étend entre une première région semiconductrice dite « de source » et une deuxième région semiconductrice dite « de drain », la première portion et la deuxième portion étant : respectivement une portion de la région de source et une portion de la région de drain.

Selon une possibilité de réalisation, afin de faciliter le refroidissement, on peut prévoir dans le substrat au moins une cavité agencée en regard du composant.

Avantageusement, chaque ilot du composant peut former une boite quantique, le dispositif comprenant en outre : un autre composant pour lire l'état quantique du composant, le dispositif comprenant en outre une structure prévue pour refroidir l'autre composant en faisant circuler un courant donné entre un élément de contact avec cet autre composant et un autre élément de contact avec cet autre composant, les éléments de contact formant au moins une jonction tunnel, en particulier de type NIS ou NS, avec une portion semiconductrice de l'autre composant.

Le composant et l'autre composant peuvent être avantageusement reliés par un ligne métallique d'interconnexion d'un niveau métallique d'interconnexions agencées dans au moins une couche isolante. Selon une configuration particulière, la ligne métallique d'interconnexion peut être entourée d'une cavité formant un espace vide autour de la ligne métallique d'interconnexion et entourée par la couche isolante. Cela participe également à un meilleur refroidissement.

Selon un autre aspect, la présente demande concerne un procédé de fabrication d'un dispositif tel que défini précédemment.

Un mode de réalisation prévoit en particulier un procédé de fabrication d'un dispositif tel que défini précédemment et comprenant des étapes consistant à :

- prévoir le substrat et le composant formé sur le substrat,
- dans au moins une couche isolante recouvrant le composant réaliser au moins un premier trou et au moins un deuxième trou dévoilant respectivement la première portion semiconductrice et la deuxième portion semiconductrice du composant,
- former le premier élément de contact dans le premier trou et le deuxième élément de contact dans le deuxième trou, en déposant au moins le matériau métallique supraconducteur donné dans le premier trou et dans le deuxième trou.

## BRÈVE DESCRIPTION DES DESSINS

La présente invention sera mieux comprise sur la base de la description qui va suivre et des dessins en annexe sur lesquels :

La Figure 1 illustre un exemple de structure pour refroidir un composant d'un dispositif quantique, le composant comportant une ou plusieurs boites quantiques formées dans une zone semiconductrice, la structure étant dotée d'éléments de contact entre lesquels on fait circuler un courant.

La Figure 2 illustre un premier exemple de réalisation particulier de la jonction tunnel de refroidissement, ici de type NS et utilisant une barrière Schottky, formée entre l'élément de contact et la portion du composant à refroidir.

La Figure 3 illustre un deuxième exemple de réalisation particulier de la jonction de refroidissement, ici de type NIS, l'isolant étant formé d'un oxyde natif entre l'élément de contact et la portion du composant à refroidir.

La Figure 4 illustre un troisième exemple de réalisation particulier de la jonction de refroidissement, ici de type NIS, l'isolant étant formé par un dépôt de matériau diélectrique entre l'élément de contact et la portion du composant à refroidir.

La Figure 5 illustre un quatrième exemple de réalisation particulier la jonction de refroidissement, ici de type NS, le contact supraconducteur étant formé de deux matériaux supraconducteurs déposés l'un après l'autre.

La Figure 6 illustre un exemple de réalisation pour lequel la structure dédiée au refroidissement est dotée d'éléments de contact à la fois sur la région de source et sur la région de drain du composant.

La Figure 7 illustre un exemple de réalisation pour lequel la structure dédiée au refroidissement est dotée d'éléments de contact sur au moins une grille de contrôle électrostatique du composant.

La Figure 8 illustre un exemple de réalisation pour lequel la structure dédiée au refroidissement est dotée d'éléments de contact à la fois sur au moins une grille de contrôle électrostatique ainsi que sur les régions de source et de drain du composant.

La Figure 9 illustre un exemple de réalisation dans lequel la structure pour refroidir est configurée pour refroidir une zone de canal dotée d'ilots de détection dédiés à la détection d'état quantique de boites quantiques.

La Figure 10 illustre un autre exemple dans lequel la structure pour refroidir est configurée à la fois pour refroidir la zone de canal pourvue d'un ou plusieurs ilots de détection et une ou plusieurs grilles de contrôle de ce ou ces ilots.

La Figure 11 illustre un exemple de réalisation où plusieurs éléments de contact de la structure de refroidissement sont reliés à une même piste supraconductrice.

Les Figures 12A, 12B, 12C, 12D illustrent un exemple de réalisation d'un composant de dispositif quantique doté d'au moins une couche semiconductrice destinée à accueillir une ou plusieurs boites quantiques.

Les Figure 12E, 12F, 12G illustrent un exemple de réalisation d'éléments de contact pour structure prévue pour refroidir le composant.

La Figure 13 illustre un exemple de réalisation dans lequel des éléments de contact de la structure pour refroidir sont en outre agencés sur des grilles de contrôle électrostatique des boites quantiques.

La Figure 14 illustre un exemple de réalisation de pistes métalliques pour permettre de polariser les éléments de contact de la structure.

La Figure 15 illustre un exemple de réalisation dans lequel la structure de refroidissement est agencée à la fois sur un premier composant destiné à accueillir une ou plusieurs boites quantiques et sur un deuxième composant prévu pour détecter l'état quantique du premier composant.

Les Figures 16A, 16B illustrent différentes possibilités d'agencements d'une matrice de composants quantiques ou qubits par rapport aux composants de contrôle associés.

La Figure 17 illustre une variante de réalisation dans laquelle, une ou plusieurs cavités sont formées dans le diélectrique et/ou dans le substrat afin de limiter le transfert thermique via ces médias et ainsi limiter l'échauffement d'un dispositif quantique comprenant des composants quantiques et de contrôle.

La Figure 18 illustre un cinquième exemple de réalisation particulier de la jonction de refroidissement, ici de type NIS, avec un contact supraconducteur formé de deux matériaux supraconducteurs empilés, le contact supraconducteur étant entouré d'une enveloppe de matériau diélectrique.

La Figure 19 illustre un sixième exemple de réalisation particulier de la jonction de refroidissement, ici de type NIS, avec un contact supraconducteur formé de deux matériaux supraconducteurs empilés et disposé sur l'oxyde,

La Figure 20 illustre un agencement avec deux jonctions tunnel de refroidissement NIS (ou NS) mises en série.

La Figure 21 illustre un agencement de jonction avec deux supraconducteurs de gap différents accolés.

Des parties identiques, similaires ou équivalentes des différentes figures décrites ci-après portent les mêmes références numériques de façon à faciliter le passage d'une figure à l'autre.

En outre, dans la description ci-après, des termes qui dépendent de l'orientation de la structure tels que « au-dessus », « au-dessous », « arrière », « avant », « supérieur », « inférieur », s'appliquent en considérant que la structure est orientée de la façon illustrée sur les figures.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

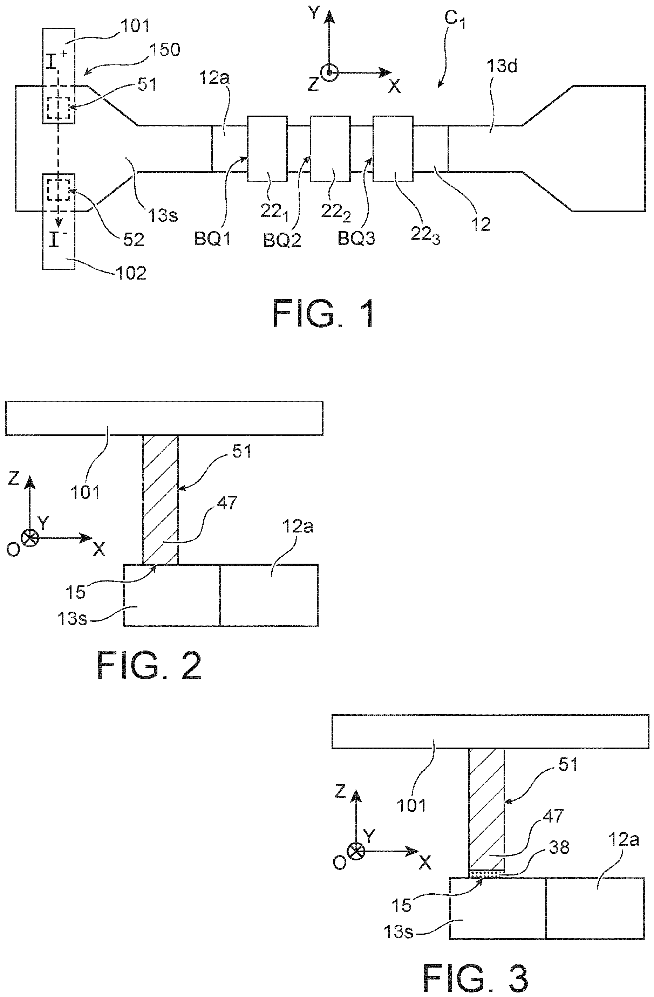

On se réfère tout d'abord à la figure 1 qui donne un exemple de réalisation particulier d'un dispositif doté d'au moins un composant $C_1$ quantique, en particulier à qubits de spin, selon un premier mode de réalisation et représenté selon une vue de dessus.

Le composant $C_1$ comportant plusieurs boites quantiques BQ1, BQ2, BQ3 formées chacune dans un ilot d'une zone 12a dite « de canal » du composant qui s'étend dans au moins une couche semiconductrice 12. Cette couche semiconductrice 12 peut être la couche superficielle d'un substrat ou une couche reportée ou déposée sur un substrat et formée d'un matériau semiconducteur ou de plusieurs matériaux semiconducteurs empilés.

Par exemple, la couche semiconductrice 12 peut être en silicium ou à base de Germanium. Selon un exemple de réalisation particulier, la couche semiconductrice 12 est la couche superficielle d'un substrat de type semiconducteur sur isolant, en particulier une couche de silicium d'un substrat SOI (SOI pour « Silicon On Insulator » ou silicium sur isolant).

Les boites quantiques BQ1, BQ2, BQ3 assurent chacune le confinement d'au moins une charge élémentaire (électron ou trou). Le spin de cette charge, en particulier d'un électron, est ici prévu pour coder l'information quantique. Les qubits associés respectivement aux boites quantiques BQ1, BQ2, BQ3 sont des qubits de spin.

Des grilles $22_1$, $22_2$, $22_3$ de contrôle électrostatique sont prévues en regard de chacun des ilots formant respectivement les boites quantiques BQ1, BQ2, BQ3 et sont, dans cet exemple de réalisation particulier, disposées au-dessus de la couche semi-conductrice 12. Les grilles $22_1$, $22_2$, $22_3$ de contrôle électrostatique peuvent être formées d'un matériau métallique tel que par exemple du TiN, ou semiconducteur tel que par exemple du polysilicium ou d'un empilement de matériau métallique et de semiconducteur.

De part et d'autre de la zone 12a, le composant comporte une région semiconductrice 13s également appelée région « de source » formant un premier réservoir de charges ou de dopants du composant C1 et une région semiconductrice 13d également appelée région « de drain » formant un deuxième réservoir de charges ou de dopants du composant C1. Les régions semiconductrices 13s, 13d, peuvent être formées par exemple à base de silicium et/ou de SiGe et/ou de Ge et sont typiquement dopées en volume.

Le dispositif a ici pour particularité d'être doté d'une structure 150 de refroidissement intégrée pour refroidir le composant C$_1$. Cette structure 150 comporte un premier élément 51 de contact et un deuxième élément 52 de contact, chacun en contact avec une région semiconductrice du composant C$_1$.

Un refroidissement du composant C$_1$ est mis en œuvre en faisant passer un courant (représenté de manière schématique sur la figure 1 par une ligne discontinue) du premier élément 51 vers le deuxième élément 52. Pour cela, on prévoit que le premier élément 51 de contact, au moins partiellement en matériau supraconducteur, forme, avec une portion semiconductrice du composant avec laquelle cet élément est en contact, au moins une jonction tunnel de refroidissement de type NIS (pour « Normal Isolant Supraconducteur ») ou au moins une jonction tunnel de refroidissement de type NS (pour « Normal Supraconducteur ») avec une barrière Schottky. Dans la deuxième configuration avec barrière Schottky, il s'agit en réalité d'un cas particulier de jonction NIS où l'Isolant « I » est remplacé par un contact métallique-supraconducteur pour former avantageusement la barrière de la jonction.

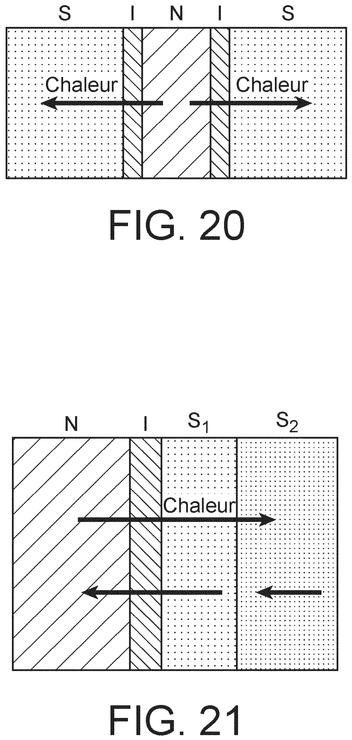

Plusieurs jonctions tunnels de refroidissement (NIS ou NS) peuvent être mises en en série et/ou en parallèle. Afin d'augmenter la puissance de refroidissement, on peut prévoir comme sur la figure 20, deux jonctions tunnel de refroidissement NIS (ou NS) mises en série pour réaliser un jonction « SINIS » et ainsi doubler la puissance de refroidissement. De préférence, on met en œuvre une symétrie des jonctions mises en série, de sorte que les épaisseurs et matériaux de leurs zones isolantes « I » sont avantageusement les mêmes d'une jonction à l'autre tandis que les épaisseurs et matériaux supraconducteurs de leurs zones « S » sont également avantageusement les mêmes d'une jonction à l'autre.

On vise pour le ou les matériaux supraconducteurs de l'élément 51 de préférence un matériau ayant une température critique Tc de supraconductivité qui soit supérieure à 2 K, avantageusement supérieure à 4 K tel que par exemple le Niobium (Nb), le nitrure de Niobium (NbN), le Nitrure de Titane (TiN), le Nitrure de Tantale (TaN), le Nitrure de Niobium - Titane (NbTiN).

Un principe de refroidissement par jonction NIS est donné dans le document « Micrometre-scale refrigerators », de Juha T Muhonen et al, 2012 Rep. Prog. Phys. 75 046501. La structure de refroidissement selon la présente invention a pour avantage d'être directement réalisé dans ou sur le composant à refroidir ce qui permet un gain en termes de compacité et d'efficacité de refroidissement.

Pour polariser de manière adéquate la jonction et faire circuler un courant susceptible de refroidir le composant, on applique pour cela de préférence entre l'élément de contact et la portion semiconductrice une tension Vr_opt égale à

$$N \frac{(\Delta - 0.66 k_B T)}{e}$$

, avec N typiquement égal à 1 ou 2 et correspondant au nombre de jonctions tunnel de refroidissement couplées électriquement en série, $\Delta$ l'écart dans la densité d'états du supraconducteur, e est la charge élémentaire, k$_B$ la constante de Boltzmann et T la température.

La gamme de tension de polarisation dépend du matériau utilisé et de la température. Par exemple, pour du TiN entre 0.1 K et 4 K, la polarisation optimale est typiquement dans la gamme 0.5 mV à 4 mV, typiquement de l'ordre de 0.7 mV à 1 K.

A une température $T < T_C$ avec Tc la température critique du matériau supraconducteur, la tension optimale Vr_opt de polarisation pour obtenir une puissance de refroidissement optimale est par exemple de l'ordre de 700 $\mu$V, pour une jonction tunnel de refroidissement de type NIS dans laquelle S est du TiN et fonctionnant à une température de 1 K. A 1 K, le TiN est particulièrement adapté pour permettre d'avoir le maximum de refroidissement. L'utilisation du TiN, couramment utilisé dans la microélectronique, est également avantageuse car elle permet la fabrication de ces jonctions de refroidissement intégrées avec des procédés industriels.

Pour un volume à refroidir de l'ordre de 1.3*10$^{-3}$ $\mu$m$^3$ (correspondant par exemple à une région semiconductrice de longueur 1 $\mu$m, de largeur de 60 nm et une épaisseur de de 20 nm, englobant le canal, la source et le drain, avec une jonction SINIS dans laquelle S est du TiN, avec une hypothèse de résistance de la barrière isolante R$_T$ de 1 k$\Omega$, on estime une puissance de refroidissement à 1 K et à la tension Vr_opt qui peut être par exemple de l'ordre de 35 pW et en tout cas supérieure à celle d'échauffement des électrons par des phonons et à l'effet Joule, l'effet Joule étant dans cet exemple particulier de l'ordre de 8 pW. De telles conditions peuvent être mises en œuvre afin par exemple de refroidir un composant tel que décrit dans le document « A new FDSOI spin qubit platform with 40nm effective control pitch », de T. Bédécarrats et al. 2021 IEEE International Electron Devices Meeting (IEDM).

Un courant de refroidissement typiquement compris entre 50 nA et 500 nA peut être mis en œuvre. Par exemple, lorsque la jonction refroidissante est de type NIS, avec le matériau supraconducteur S du TiN à 1K, un courant de 120 nA peut être mis en œuvre.

Le premier élément 51 de contact et le deuxième élément 52 de contact s'étendent ici dans une direction réalisant un angle non-nul avec un plan principal du substrat ou de la couche semiconductrice 12, en particulier une direction orthogonale à ce plan principal. Par « plan principal » du substrat ou de la couche semi-conductrice 12 on entend un plan passant par le substrat ou la couche semiconductrice 12 et qui est parallèle au plan [O ;x ;y ] du repère orthogonal [O ;x ;y ;z ].

Pour permettre de leur appliquer des signaux et/ou potentiels de polarisation, le premier élément 51 de contact et le deuxième élément 52 de contact sont ici reliés respectivement à une première piste 101, typiquement métallique et de préférence supraconductrice et une deuxième piste 102 typiquement métallique et de préférence supraconductrice. Par exemple, les pistes 101, 102 peuvent être formées à l'aide d'un ou plusieurs des matériaux supraconducteurs suivants : TiN, Nb, NbN, NbTiN, TaN. Les pistes métalliques 101 et 102 peuvent appartenir à un niveau métallique d'interconnexion, par exemple du premier niveau métallique $M_1$ d'interconnexion, c'est-à-dire celui prévu juste au-dessus de la couche semiconductrice et des contacts.

Pour permettre l'établissement du courant de refroidissement entre les éléments 51 et 52 de contact, les pistes métalliques 101, 102 sont ici mises à des potentiels différents et en particulier de sorte que cette différence de potentiels corresponde à une tension Vr_opt.

Différents exemples de configurations de l'élément de contact 51 sont donnés sur les figures 2 à 5, et 18-19.

Selon un premier exemple de réalisation particulier illustré sur la figure 2, le premier élément 51 de contact est entièrement en matériau métallique supraconducteur 47, par exemple du TiN, ou du TaN ou un empilement Ti/TiN qui peut être déposé par un procédé de dépôt conforme tel que la CVD (« Chemical Vapor Deposition », i.e. dépôt chimique en phase vapeur), et est disposé directement en contact sur une portion 15 semiconductrice qui peut être dopée, par exemple dopée N. Cette portion 15 semiconductrice est ici par exemple une portion de la région 13s de source du composant.

On crée ainsi une barrière Schottky entre l'élément 51, et la portion semiconductrice du composant avec laquelle cet élément 51 se trouve en contact, formant ainsi une jonction tunnel de refroidissement de type NS pour « Normal Supraconducteur ». Le matériau métallique 47 supraconducteur, se trouve alors directement en contact sur une portion 15 semiconductrice dopée qui, de préférence, n'est pas siliciurée ou ne comporte pas de zone d'alliage de métal et de semiconducteur comme dans un contact conventionnel de transistor. La portion semiconductrice 15 avec laquelle cet élément 51 se trouve en contact est ici de préférence fortement dopée, c'est-à-dire de l'ordre de $10^{20}cm^{-3}$ ou supérieur.

Un deuxième exemple de réalisation de l'élément 51 de contact est donné sur la figure 3. L'élément 51 est cette fois formé d'un tronçon principal en matériau métallique supraconducteur 47 relié à la piste 101 et d'une zone 38 diélectrique, d'épaisseur qui peut être comprise par exemple entre 2 et 10 nm et qui est agencée entre une extrémité du tronçon de matériau 47 métallique supraconducteur et la portion semiconductrice, de préférence dopée, du composant avec laquelle l'élément 51 est en contact. La portion semiconductrice 15 dopée par exemple d'une région de source 13s, la zone 38 diélectrique, et le tronçon de matériau 47 métallique supraconducteur forment ici une jonction tunnel de refroidissement de type NIS (pour « Normal Isolant Supraconducteur »).

Avantageusement, la zone 38 diélectrique peut être une zone d'oxyde semiconducteur, en particulier formée par oxydation, native ou assistée, du matériau semiconducteur de la portion 15 semiconductrice dopée, par exemple une zone de $SiO_2$, lorsque la portion semi-conductrice dopée est en silicium.

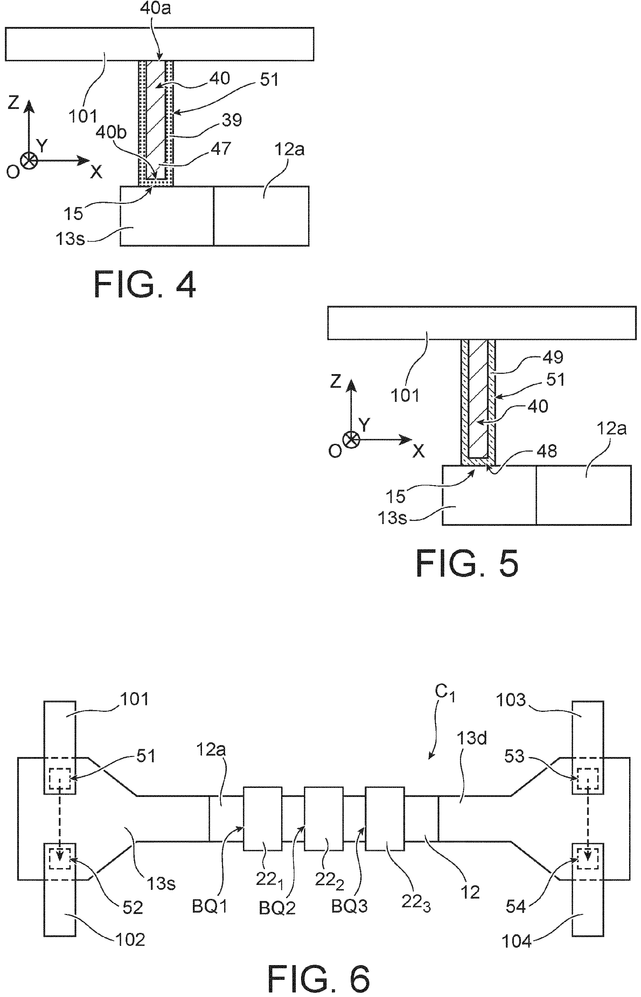

Selon une variante de réalisation illustrée sur la figure 4, l'élément 51 de contact est cette fois formé d'une partie centrale 40 en matériau métallique supraconducteur 47, par exemple sous forme d'une tige, dont une extrémité 40a est en contact avec la piste 101. Cette partie centrale 40 est entourée d'une enveloppe 39 en matériau diélectrique, qui s'étend contre les flancs latéraux de la partie centrale 40 et recouvre ici une autre extrémité 40b opposée à l'extrémité 40a. L'enveloppe 39 diélectrique est elle-même en contact avec la portion semiconductrice dopée (ici la région de source 13s). Ainsi, la portion semiconductrice dopée, l'enveloppe 39 diélectrique, et la partie centrale 40 de matériau 47 métallique supraconducteur forment une jonction tunnel de refroidissement de type NIS. L'enveloppe 39 diélectrique peut être par exemple à base de $SiO_2$ déposé par exemple par PECVD (pour « Plasma Enhanced CVD », i.e. « CVD assisté par plasma ») ou par PEALD (pour « Plasma Enhanced Atomic Layer Deposition », i.e. Dépôt en couche atomique assisté par plasma) ou d'un diélectrique high-k tel que par exemple de l'$Al_2O_3$ ou du $HfO_2$ déposé par PEALD.

Selon une autre possibilité de réalisation, on peut former l'élément 51 de contact d'une superposition de plusieurs matériaux métalliques supraconducteurs différents avec, de préférence, le matériau métallique supraconducteur ayant le gap supraconducteur le plus grand qui est placé en contact avec la portion semi-conductrice dopée.

Ainsi, dans l'exemple de réalisation particulier illustré sur la figure 5, l'élément 51 est cette fois formé d'un partie centrale 40, en matériau métallique supraconducteur 47 entourée d'une enveloppe 48, en un matériau métallique supraconducteur 49 différent du matériau métallique supraconducteur 47 et ayant en particulier un plus grand gap que le matériau métallique supraconducteur 47. L'enveloppe 48 est en contact avec la portion semi-conductrice dopée (ici la région de source 13s). La portion semi-conductrice dopée, l'enveloppe 48 et la partie centrale 40 forment ici une jonction de refroidissement de type NS. Par exemple, on peut prévoir l'enveloppe 48 en TiN, et la partie centrale 40 en Aluminium. Une telle configuration du matériau métallique supraconducteur 49 ayant le plus grand Gap contre la portion semiconductrice dopée permet d'éviter que des électrons chauds ne reviennent vers la partie normale « N » de la jonction « NS » (ou « NIS »), et donc d'augmenter les performances du refroidissement.

Un mode de réalisation tel que décrit précédemment avec une superposition de matériaux supraconducteurs peut être combiné avec l'un ou l'autre de ceux précédemment décrits, en particulier en lien avec la figure 3 ou avec la figure 4.

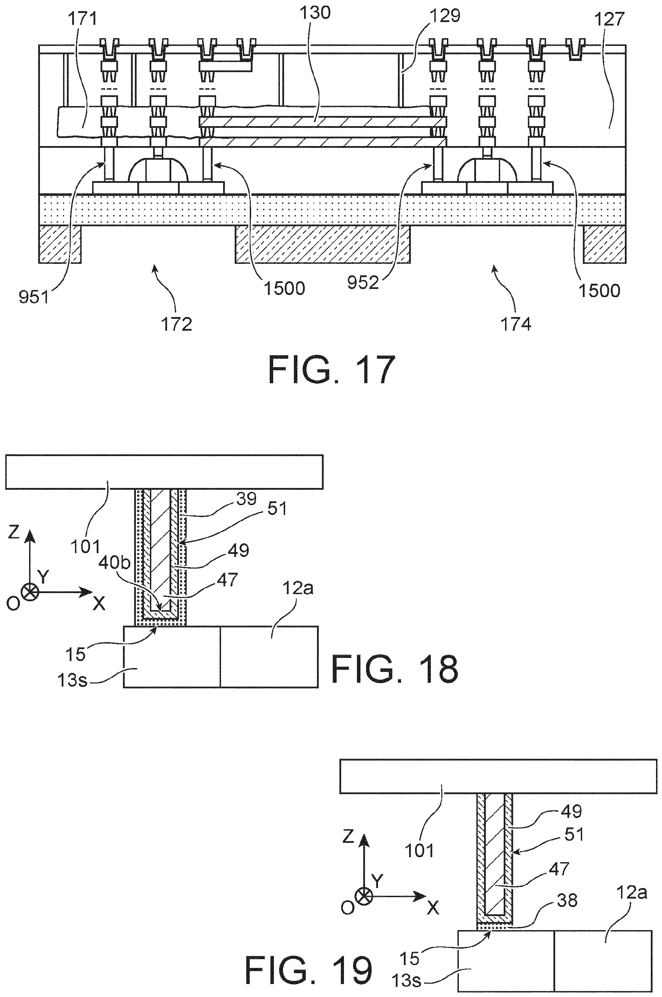

Ainsi, un élément 51 formé d'une superposition de deux matériaux supraconducteurs 47, 49 peut être lui-même entouré d'une enveloppe 39 diélectrique comme sur la figure 18 et/ou être disposé sur une zone 38 diélectrique formée d'un oxyde semi-conducteur comme sur la figure 19.

On peut ainsi mettre en œuvre une configuration NIS152 telle qu'illustrée sur la figure 21, avec « N » la zone normale formée par la portion semi-conductrice dopée, « I » la zone isolante, « S1 », le matériau supraconducteur de gap le plus élevé, et « S2 » un matériau supraconducteur de gap plus faible que le matériau supraconducteur « S1 ».

Le deuxième élément de contact 52 par lequel le courant I sort, peut être avantageusement doté d'une structure qui peut être identique à celle du premier élément 51 et/ou reprenant l'un ou l'autre des agencements décrits précédemment en liaison avec les figures 2 à 5. Ainsi, on peut prévoir de réaliser un agencement de type SINIS (pour Supraconducteur Isolant Normal Isolant Supraconducteur) avec deux jonctions NIS en série. Un tel agencement et une symétrisation des jonctions, de préférence lorsqu'au moins les zones supraconductrices sont identiques, peut permettre d'augmenter davantage la puissance de refroidissement.

Un exemple de réalisation particulier de dimensionnement d'éléments du composant C1 de la figure 1 est donné dans le tableau ci-après, dans le cas particulier où les éléments 51, 52 ont une configuration telle que par exemple sur la figure 2, 3 ou 4 et forment une jonction:

| Niveau | DIMENSIONNEMENT : | | |
|---|---|---|---|
| | Epaisseur (dimension mesurée parallèlement à l'axe z) | Largeur (dimension mesurée parallèlement à l'axe y) | Longueur (dimension mesurée parallèlement à l'axe x) |
| Piste 101 | 10 à 500 nm | 50 nm à 50 $\mu$m | > 100 nm |
| Élément 51, 52 ou partie 40 de cet élément 51, 52 | 50 à 200 nm | 30 à 100 nm | 30 à 100 nm |
| Diélectrique 38 ou 39 | 2 à 10 nm | 30 à 100 nm | 30 à 100 nm |
| Région 13s, 13d de Source/drain | 10 à 30 nm | 40 à 300 nm | > 50 nm |
| Canal 12a | 10 à 20 nm | 30 à 60 nm | > 100 nm |
| Grille $22_1$ | 20 à 50 nm | > 100 nm | 20 à 50 nm |

Dans l'exemple de réalisation décrit précédemment en liaison avec la figure 1, on prévoit de disposer la structure 150 pour refroidir le composant $C_1$ sur sa région 13s de source.

En variante, on peut disposer une telle structure 150 sur le deuxième réservoir de charges ou de dopants, autrement dit sur la région 13d de drain du composant C1.

On peut également disposer une telle structure 150 à la fois sur la région 13d de drain et sur la région de source 13s.

Ainsi, sur la figure 6, la structure 150 pour refroidir le composant $C_1$, munie des éléments 51, 52 en contact sur la région 13s de source est également dotée d'autres éléments 53, 54 de contact sur la région 13d de drain. La structure 150 de refroidissement comporte ainsi un troisième élément 53 de contact et un quatrième élément 54 de contact, chacun en contact avec la région semiconductrice 13d de drain. Le troisième élément 53 et le quatrième élément 54 de contact sont ici reliés respectivement à une troisième piste métallique 103 et une quatrième piste métallique 104, pour permettre de leur appliquer des potentiels de polarisation et/ou signaux adéquats. La troisième piste métallique 103 et la quatrième piste métallique 104 peuvent être formées dans le même niveau d'interconnexion que les pistes 101, 102 et sont de préférence en matériau métallique supraconducteur, par exemple à base du même matériau métallique supraconducteur que les pistes 101, 102. Le troisième élément 53 et le quatrième élément 54 peuvent avoir une structure semblable à celle du premier élément 51 et/ou reprenant l'une ou l'autre des configurations décrites précédemment en liaison avec les figures 2 à 5, 18, 19. Le courant de refroidissement susceptible d'être établi entre les éléments 51, 52 et celui entre les éléments 53, 54 sont représentés par des lignes discontinues.

En variante de l'un ou l'autre des exemples décrits précédemment, on peut prévoir la structure 150 de refroidissement cette fois au niveau d'une ou plusieurs grilles de contrôle de(s) boite(s) quantique(s).

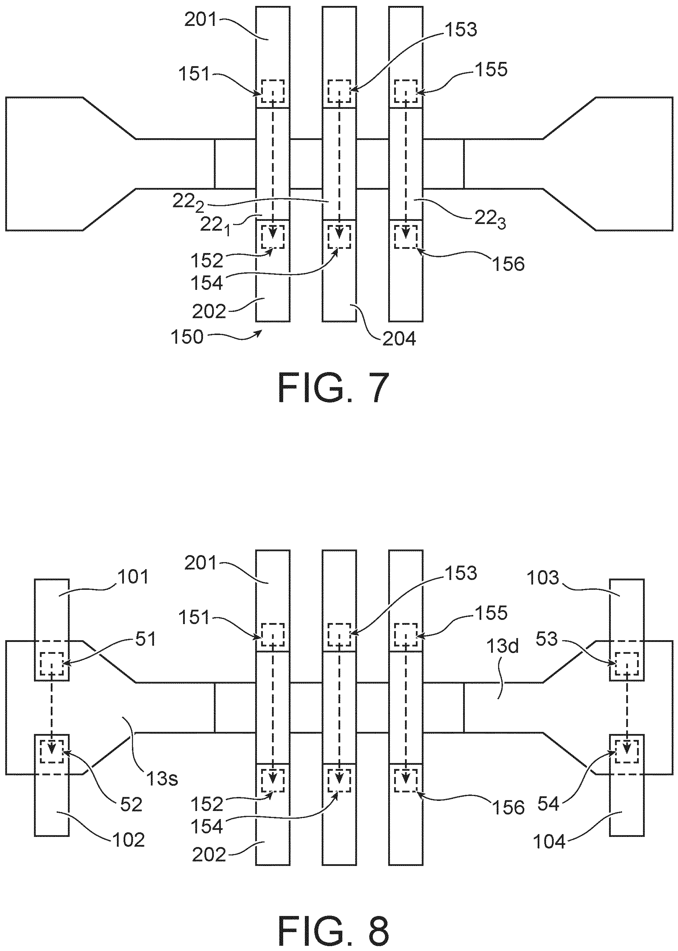

Ainsi, dans l'exemple de réalisation illustré sur la figure 7, on dispose un élément 151 de contact et un autre élément 152 de contact, chacun en contact avec une grille de contrôle électrostatique, le et/ou les élément(s) 151 de contact formant chacun avec une portion de grille $22_1$, en particulier une portion semiconductrice de préférence dopée avec laquelle il est (sont) en contact, une jonction tunnel de refroidissement, en particulier de type NIS ou NS.

Les éléments 151, 152 de contact peuvent avoir une structure semblable à celle de l'élément 51 décrit précédemment et/ou une configuration selon l'une ou l'autre des possibilités décrites précédemment en liaison avec les figures 2 à 5, 18, 19. Les éléments 151, 152 de contact sont ici également reliés respectivement à une piste métallique 201 et une piste métallique 202 à base d'un matériau supraconducteur, typiquement formées dans un niveau métallique d'interconnexions, par exemple le premier niveau M1 communément appelé de « métal 1 ». Dans l'exemple de réalisation particulier de la figure 7, chacune des grilles de contrôle peut être refroidie. Ainsi, sur une deuxième grille de contrôle $22_2$ on dispose également des éléments 153, 154 de contact pour faire circuler un courant, tandis que sur une troisième grille de contrôle $22_3$ des éléments 155, 156 de contact sont également agencés pour faire circuler un courant permettant de refroidir cette grille $22_3$.

Un autre mode de réalisation prévoit une structure de refroidissement en partie formée sur au moins une des régions de source et/ou de drain et en partie formée sur une ou plusieurs grilles de contrôle.

Ainsi, dans un autre exemple de réalisation illustré sur la figure 8, on prévoit le premier élément 51 et le deuxième élément 52 en contact avec la région de source 13s, le troisième élément 53 et le quatrième élément 54 en contact avec la région de drain 13d, et les éléments 151, 152, 153, 154, 155, 156 en contact chacun avec une grille de contrôle $22_1$, $22_2$, $22_3$. On peut ainsi faire circuler des courants de refroidissement respectivement à travers la région de source 13s, à travers la région de drain 13d et à travers chacune des grilles $22_1$, $22_2$, $22_3$.

Dans l'un ou l'autre des exemples décrits précédemment, on prévoit une structure de refroidissement permettant de faire circuler un courant dans une région de source et/ou dans une région de drain et/ou dans une ou plusieurs grilles de contrôle électrostatique d'un composant $C_1$ prévu pour accueillir une ou plusieurs boites quantiques BQ1, BQ2, BQ3.

On peut également appliquer une telle structure de refroidissement à une autre partie du composant $C_1$ ou bien à un autre composant, dédié(e) cette fois à une détection d'état(s) quantique(s), par exemple de l'état ou les états respectifs des boites quantiques BQ1, BQ2, BQ3 du composant $C_1$.

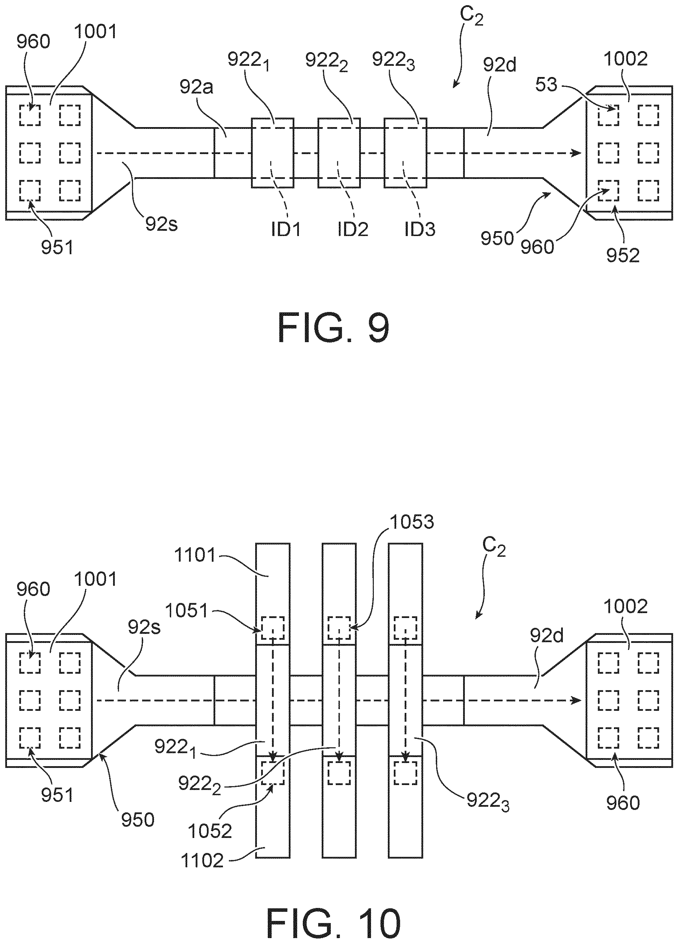

Dans l'exemple de réalisation illustré sur la figure 9, une structure de refroidissement 950 est prévue sur un autre composant $C_2$ comportant une zone 92a dite « de canal », semi-conductrice agencée entre une région semiconductrice de source 92s et une région semiconductrice de drain 92d.

Des grilles $922_1$, $922_2$, $922_3$ de contrôle électrostatique sont prévues en regard d'ilots semi-conducteurs ID1, ID2, ID3 de la zone de canal 92a, ici appelés « ilots de détection » et prévus chacun pour détecter l'état quantique d'une boite quantique (non représentée) associée. Le dispositif est ici pourvu d'une structure 950 pour refroidir le composant $C_2$ en faisant circuler un courant dans la zone 92a de canal, par exemple de la région semiconductrice de source 92s vers la région semiconductrice de drain 92d. La structure 950 comporte ainsi un élément 951 de contact et un élément 952 de contact, respectivement en contact avec la région semiconductrice de source 92s et la région semiconductrice de drain 92d, les éléments 951, 952 de contact formant chacun avec des portions semiconductrices des régions de source et de drain au moins une jonction tunnel de refroidissement, en particulier de type NIS ou NS. Dans la mesure où les ilots de détection ID1, ID2, ID3 du composant $C_2$ sont adaptés ici pour lire un état quantique plutôt que pour stocker un état quantique, une circulation de courant à travers la zone 92a de canal afin de refroidir le composant $C_2$, ne risque pas d'altérer ou faire perdre l'information quantique.

Selon un mode de réalisation particulier, la structure de refroidissement 950 est avantageusement dotée d'éléments 951, 952 formés ici de plusieurs plots 960 mis en parallèle et en contact chacun avec une portion semiconductrice de région de source 92s ou de drain 92d. Chaque plot de contact 960 peut avoir une structure semblable à celle d'un élément 51 de contact tel que décrit précédemment et/ou tel qu'illustré sur l'une des figures 2 à 5, 18, 19.

Les plots de contact 960 de l'élément 951 de contact sont ici reliés en parallèle à une même piste métallique 1001, de préférence en matériau supraconducteur métallique. De même, les plots de contact 960 de l'élément 952 de contact peuvent être reliés en parallèle à une même piste métallique 1002, de préférence en matériau supraconducteur métallique. Une telle parallélisation des jonctions tunnel de refroidissement peut permettre d'améliorer le refroidissement en diminuant la résistance totale de la jonction $R_T$. Les pistes métalliques 1001, 1002 peuvent être, là encore, des pistes d'un même niveau métallique d'interconnexion, par exemple du premier niveau métallique d'interconnexion noté « métal 1 ».

Une telle parallélisation des contacts peut être également adaptée sur la région de source 13s et/ou sur la région de drain 13d voire sur la ou les grilles de contrôle du premier composant $C_1$.

Un autre exemple de réalisation illustré sur la figure 10, diffère de celui précédemment décrit en ce que la structure 950 pour le refroidissement du composant $C_2$ prévoit en outre un élément 1051 de contact et un autre élément 1052 de contact, chacun en contact avec une grille de contrôle électrostatique $922_1$, le ou les éléments 1051, 1052 de contact formant chacun avec une portion de grille, en particulier un portion semi-conductrice de préférence dopée avec laquelle il(s) est (sont) en contact une jonction tunnel de refroidissement, en particulier de type NIS ou NS.

Les éléments 1051, 1052 de contact peuvent avoir une structure semblable à celle de l'élément 51 décrit précédemment et/ou une composition selon l'une ou l'autre des possibilités décrites précédemment en liaison avec les figures 2 à 5, 18, 19.

Les éléments 1051, 1052 de contact sont également typiquement reliés respectivement à des pistes métalliques 1101, 1102 de matériau métallique supraconducteur et réalisé au même niveau d'interconnexion que les pistes 1001, 1002.

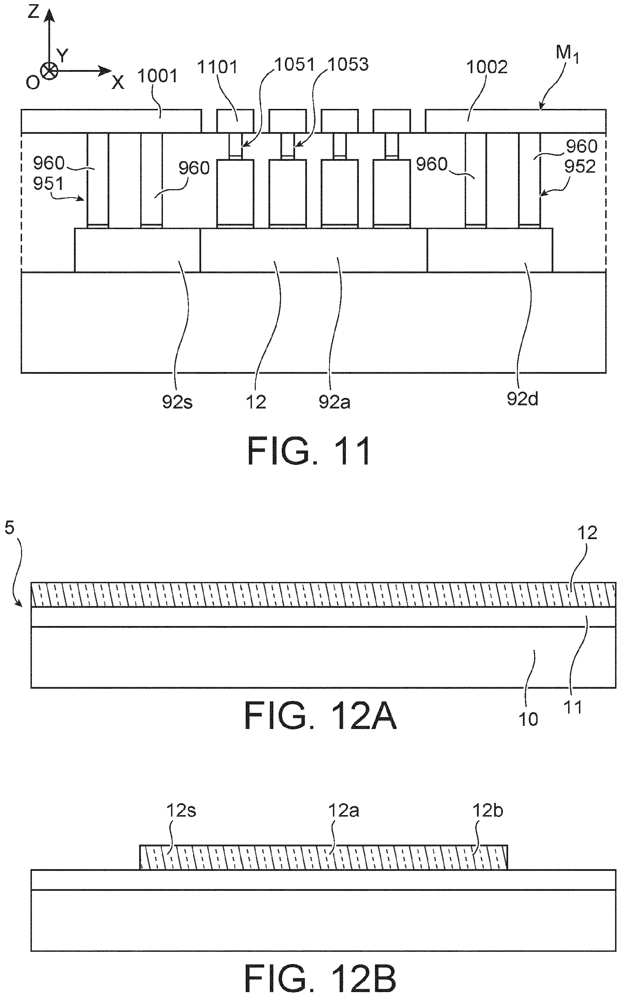

Un dispositif ayant un agencement similaire et cette fois vue en coupe est illustré sur la figure 11, avec des éléments de contact 1051, 1053 de grilles distinctes.

Dans cet exemple de réalisation particulier, les régions de source 92s, la zone de canal 92a et la région de drain 92d du composant $C_2$ sont ici formées dans une même couche semi-conductrice 12.

Un exemple de procédé de réalisation d'un dispositif quantique d'un type tel que décrit précédemment, va à présent être donné en lien avec les figures 12A-12F.

Une structure de départ possible pour la réalisation du dispositif se trouve ici sous forme d'un substrat 5 de type semiconducteur sur isolant dont la couche superficielle 12, d'épaisseur qui peut être par exemple comprise entre 5 nm et 25 nm, par exemple de l'ordre de 12 nm, est ici destinée à accueillir des boites quantiques. Le substrat 5 de type semiconducteur sur isolant peut être en particulier un substrat de type SOI (pour « Silicon On Insulator » soit « silicium sur isolant ») avec une couche superficielle 12 en silicium, par exemple du $^{28}Si$, en particulier lorsque cette couche est amenée à accueillir des qubits de spin d'électrons. La couche isolante 11 et la couche de support 10 du substrat 5 sont typiquement, respectivement, une couche en oxyde de silicium communément appelée de « BOX » (pour « Burried Oxide » ou « oxyde enterré ») et une couche semi-conductrice, par exemple à base de silicium. L'épaisseur de la couche isolante 11 peut être par exemple comprise entre 20 nm et 200 nm, par exemple de l'ordre de 145 nm.

On définit ensuite dans la couche semiconductrice 12 un ou plusieurs motifs, dont, comme sur la figure 12B, un motif comportant une zone de canal 12a disposée entre une zone semiconductrice 12s destinée à former une région source et une autre zone semi-conductrice 12d destinée à former une région de drain.

Un empilement de grille recouvrant la couche semiconductrice superficielle 12 est également réalisé. Cet empilement de grille comprend une couche de diélectrique 17 de grille, tel que par exemple de l'oxyde de silicium ou un diélectrique high-k tel que par exemple de l'$Al_2O_3$ ou du $HfO_2$. La couche diélectrique de grille peut être par exemple réalisée avec une épaisseur par exemple comprise entre 2 nm et 20 nm.

La couche de diélectrique 17 de grille est surmontée d'au moins une couche 18 de matériau de grille qui peut être formée par exemple par CVD (« Chemical vapor deposition », i.e. dépôt chimique en phase vapeur) et d'épaisseur par exemple comprise entre 20 nm et 50 nm. La couche 18 de matériau de grille peut être formée d'au moins un matériau semiconducteur tel que par exemple du polysilicium ou d'un empilement de métal et de semiconducteur par exemple de TiN suivi de polySi.

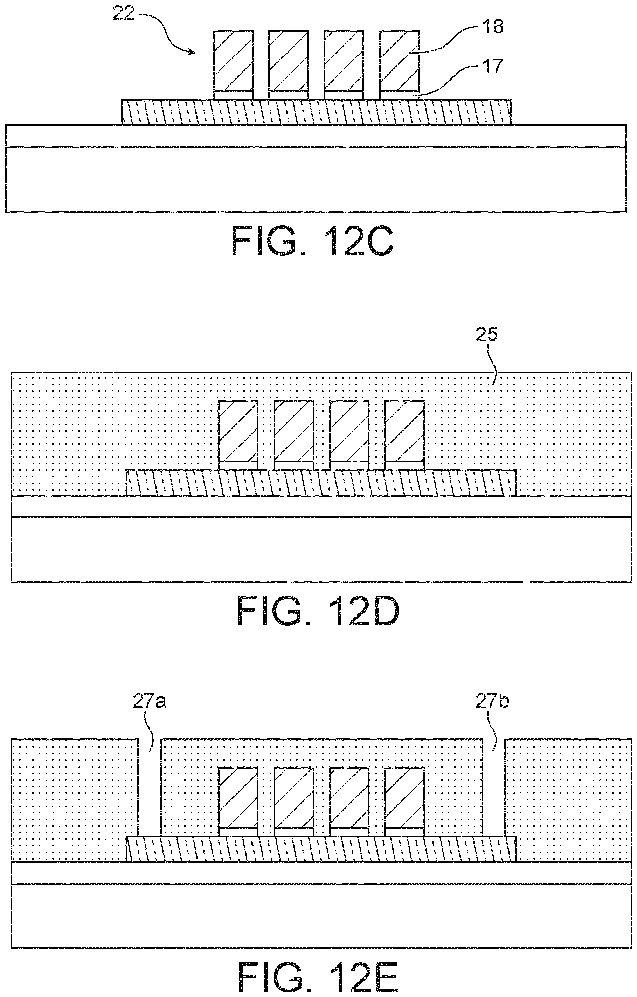

On définit ensuite (figure 12C) une ou plusieurs électrodes de grille dans l'empilement de grille typiquement en formant un masquage dans lequel on réalise des motifs que l'on reproduit ensuite dans l'empilement de grille, par exemple par gravure anisotrope.

Une telle étape peut être éventuellement suivie de la réalisation d'espaceurs isolants (non représentés), de part et d'autre des électrodes de grilles, par exemple par dépôt de SiN puis gravure.

Ensuite, là encore de manière optionnelle, une croissance de matériau semiconducteur par épitaxie afin d'accroitre l'épaisseur de régions de source et de drain et former des régions de source et de drain dites « surélevées » peut être mise en œuvre.

Une telle étape peut être accompagnée ou suivie d'une étape de dopage des régions de source et de drain. On peut réaliser par exemple un tel dopage par implantation et/ou de manière *in situ* lors de la croissance par épitaxie.

D'autres espaceurs isolants peuvent être ensuite réalisés. Dans le cas où les jonctions du dispositif sont siliciurées, ces espaceurs supplémentaires permettent de contrôler la position du front de siliciuration par rapport aux régions dopées.

On peut recouvrir ensuite l'ensemble d'une épaisseur isolante 25 (figure 12D). Cette épaisseur isolante 25 peut être formée d'une couche isolante de type CESL (« contact etch stop layer ») par exemple en nitrure de silicium et d'une couche de type PMD (« pre-metal dielectric »).

On peut alors ensuite procéder à la réalisation de la structure de refroidissement.

Pour former le ou les éléments de contact de la structure de refroidissement, on pratique alors un ou plusieurs trous dans l'épaisseur isolante 25. Une telle réalisation comprend typiquement des étapes de photolithographie et de gravure. Dans l'exemple de réalisation particulier illustré sur la figure 12E, on réalise un trou 27a en regard d'une zone destinée à contacter électriquement une région de source ainsi qu'un trou 27b en regard d'une zone destinée à contacter électriquement une région de drain.

Dans un cas particulier tel que décrit précédemment en lien avec les figures 3 et 4, où l'on souhaite réaliser des éléments de contact formant une jonction refroidissante de type NIS, on forme au fond des trous 27a, 27b une zone diélectrique 38, par exemple par oxydation du matériau semiconducteur situé au fond des trous 27a, 27b et/ou par dépôt de matériau diélectrique. Un dépôt par PECVD (« Plasma Enhanced Chemical Vapor Deposition », i.e. dépôt chimique en phase vapeur assisté par plasma) ou PEALD (« Plasma Enhanced Atomic Layer Deposition », i.e. « dépôt par couche atomique assisté par plasma) peut être en particulier mis en œuvre.

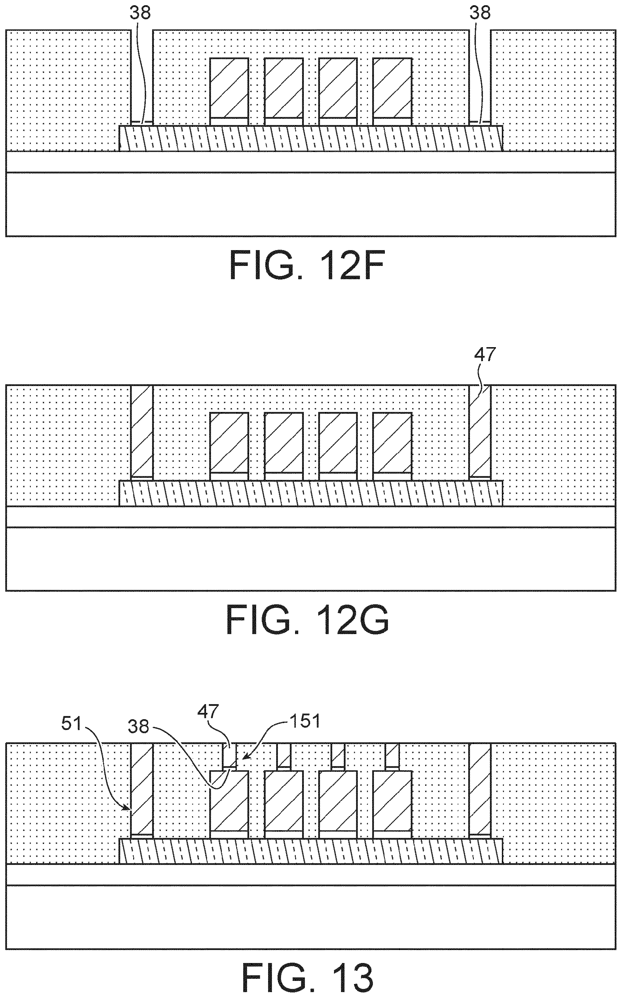

Dans l'exemple particulier illustré sur la figure 12F, la zone de matériau diélectrique 38 ne s'étend qu'au fond des trous. Toutefois, cette zone diélectrique peut, en variante, en particulier dans le cas d'une réalisation par dépôt, être agencée en une couche conforme tapissant le fond ainsi que les parois verticales des trous 27a, 27b.

On remplit ensuite ces trous 27a, 27b à l'aide d'un matériau métallique 47 (figure 12G) supraconducteur, par exemple du TiN ou TaN ou un empilement de Ti/TiN ou TaN/Ta. Un tel remplissage peut être réalisé par CVD et suivi typiquement d'une étape de planarisation par CMP (« Chemical mechanical polishing », i.e. polissage mécano-chimique) afin de retirer du matériau métallique dépassant de l'embouchure des trous 27a, 27b.

La figure 13, illustre un cas avantageux où l'on prévoit des éléments de contact supplémentaires sur les grilles 22. La réalisation de ces éléments peut être alors semblable à celle qui vient d'être donnée pour former des éléments de contact sur les régions de source et de drain. Ainsi, on pratique dans l'épaisseur isolante 25 un ou plusieurs autres trous en regard respectivement de la ou les électrodes de grille. On forme au fond de ces autres trous une zone diélectrique 38. Puis, on remplit ensuite ces autres trous d'un matériau métallique 47 supraconducteur. Un tel remplissage peut être suivi d'une étape de planarisation par CMP afin de retirer le matériau métallique dépassant de l'embouchure des trous.

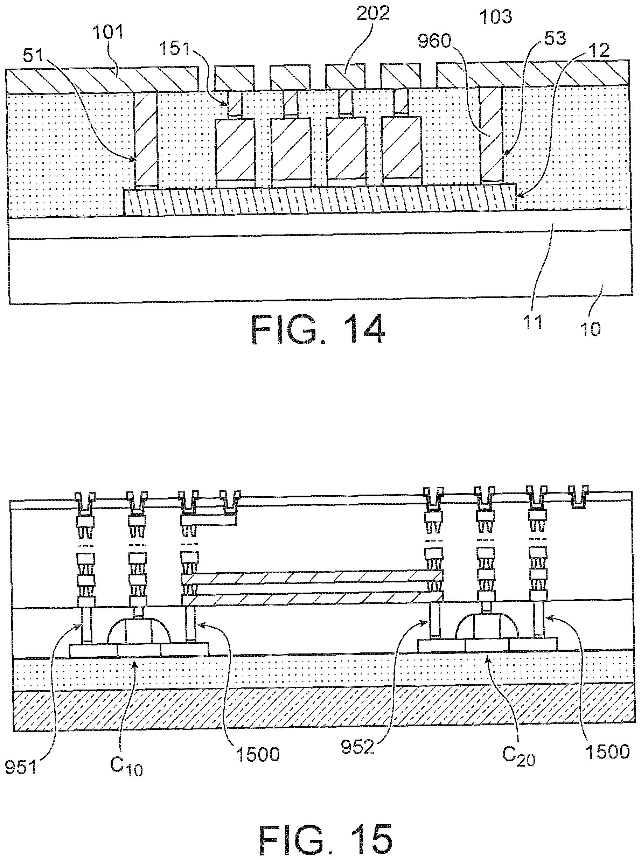

On peut ensuite former comme sur la figure 14, une ou plusieurs pistes métalliques 101, 103, 202, sur le ou les éléments de contact 51, 53, 151 réalisés, par exemple par dépôt et gravure d'un matériau métallique supraconducteur qui peut être choisi parmi un ou plusieurs des matériaux suivants : TiN, Nb, NbN, NbTiN, TaN.

Une structure 1500 pour le refroidissement à la fois de composants $C_{10}$ d'un circuit à qubits semiconducteurs co-intégrés avec des composants $C_{20}$ d'un circuit électronique dédié au contrôle et/ou à la lecture des qubits, par exemple sous forme de transistors, en particuliers des transistors de type cryoCMOS, est illustrée sur la figure 15 avec des éléments 951, 952 de contact formant au moins une jonction tunnel de refroidissement, en particulier de type NIS ou NS et disposés respectivement sur des portions semiconductrices des composants $C_{10}$, $C_{20}$.

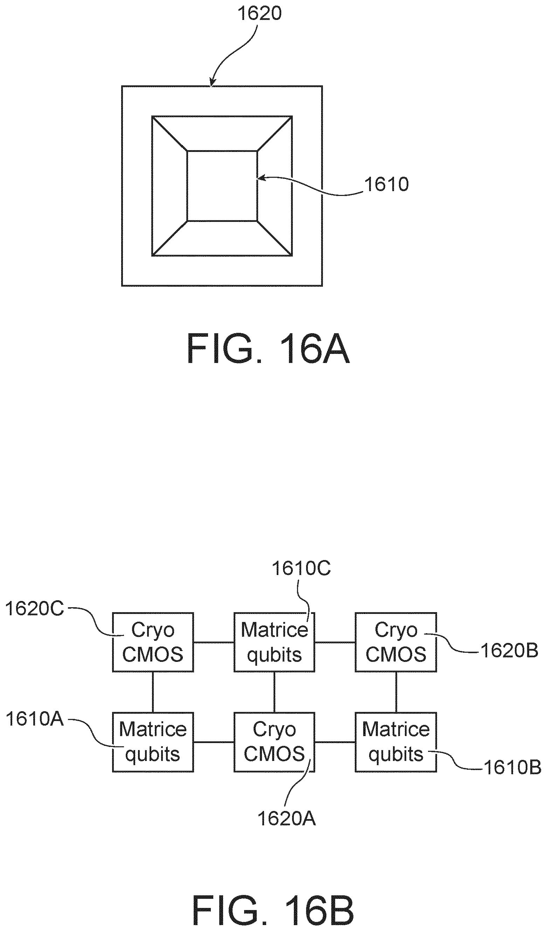

Une telle structure 1500 s'adapte à différents types d'agencements des composants $C_{10}$, $C_{20}$ et des circuits auxquels ils appartiennent notamment aussi bien à un agencement par exemple comme sur la figure 16A où les composants de contrôle $C_{20}$ d'un circuit 1620 dédié à la lecture et/ou au contrôle des qubits sont répartis en périphérie d'un composant quantique agencé en circuit matriciel 1610 à qubits, qu'à une répartition, par exemple sur la figure 16B avec plusieurs circuits matriciel 1610A, 1610B, 1610C à qubits entre lesquels des circuits 1620A, 1620B, 1620C dédié à la lecture et/ou au contrôle des qubits sont disposés.

Une structure telle que décrite précédemment pour le refroidissement d'un dispositif quantique peut être co-intégrée avec plusieurs autres moyens ou éléments permettant de favoriser ce refroidissement ou de limiter l'échauffement.

Ainsi, par exemple, une ou plusieurs cavités structurées dans un substrat sur lequel le dispositif quantique est réalisé peuvent être prévues. La mise en œuvre de telles cavités est prévue dans la demande de brevet déposée devant l'INPI émanant de la demanderesse et ayant pour numéro de dépôt : FR2310911

De même, au moins une cavité autour de niveaux métalliques d'interconnexion peut être mise en œuvre afin de pouvoir mieux évacuer la chaleur.

Dans l'exemple de réalisation illustré sur la figure 17, on prévoit en particulier une cavité 172 réalisée dans la couche 10 de support d'un substrat en regard de composants $C_{10}$ du circuit à qubits. De même, dans la couche 10 de support de ce substrat, on prévoit une autre cavité 174 en regard des composants de contrôle à base de transistors de type cryoCMOS $C_{20}$ du circuit électronique dédiés au contrôle et/ou à la lecture des qubits. De telles cavités 172, 174 typiquement réalisées par gravures localisées du substrat permettent de limiter les fuites thermiques par ce dernier.

Dans cet exemple de réalisation, un autre type de cavité 171 est pratiqué cette fois dans au moins une couche isolante 127 encapsulant une ou plusieurs lignes métalliques d'interconnexion. Une telle cavité 171 peut en particulier être réalisée autour d'au moins une ligne métallique 130 de connexion entre composants $C_{10}$ du circuit à qubits et composants $C_{20}$ du circuit électronique dédiés au contrôle et/ou à la lecture des qubits. La cavité 171 forme un espace vide ou rempli d'air (« airgap » selon la terminologie anglosaxonne) autour de la ligne métallique d'interconnexion et entouré par ladite couche isolante 127. Ce type de cavité permet de limiter les fuites thermiques par le diélectrique présent entre les niveaux d'interconnexion. Combinée à l'utilisation de matériau supraconducteur pour la ligne métallique d'interconnexion 130, elle permet d'assurer une isolation thermique optimisée entre les composants $C_{10}$ et $C_{20}$. On peut la mettre en œuvre notamment en réalisant des ouvertures 129 ou tranchées 129 à travers la couche isolante 127 et en effectuant une gravure de matériau isolant exposé par le fond de ces ouvertures ou tranchées 129.

Une structure de refroidissement telle que décrite précédemment peut être également intégrée à un dispositif tel que décrit dans les demandes EP3971983 A1, et EP3971982A1 issues de la demanderesse et dans lequel on prévoit un routage mixte avec à la fois des lignes ou pistes de routage et/ou d'interconnexions en matériau conducteur et des lignes ou pistes en matériau supraconducteur sur différents niveaux métalliques d'interconnexions de niveau(x) dits de BEOL (pour « back end of line »).

Par exemple un tel routage mixte comporte des lignes métalliques de connexions horizontales entre qubits et transistors cryoCMOS prévues en matériau métallique supraconducteur, tandis que des éléments de connexions verticaux ou vias sont en matériau métallique conventionnel. Un tel routage mixte peut également comprendre par exemple des lignes de connexion entre composants à qubits ou cryoCMOS en matériau métallique supraconducteur d'une part et des lignes de connexion à un circuit de lecture extérieur d'autre part en matériau métallique conventionnel tel que par exemple du Cu ou du W.

EP 4 622 439 A1

**Revendications**

1. Dispositif électronique quantique, en particulier à qubits de spin, comprenant un substrat et un composant ($C_1$, $C_2$, $C_{10}$) disposé sur le substrat, le composant comportant au moins une zone (12a, 92a) dite « de canal » formée dans au moins une couche semiconductrice (12) et comportant un ou plusieurs ilots, chaque ilot étant contrôlé par le biais d'une grille de contrôle électrostatique et formant une boite quantique ou un ilot de détection pour lire l'état quantique d'une boite quantique, le dispositif comprenant en outre : une structure (150, 950) prévue pour refroidir ledit composant ($C_1$, $C_2$, $C_{10}$) en faisant circuler un courant donné entre un premier élément (51, 151, 951) de contact avec le composant et un deuxième élément (52, 152, 952) de contact avec le composant, le premier élément (51, 151, 951) de contact comprenant au moins un matériau métallique supraconducteur (47) donné et étant en contact par une première extrémité avec une première portion semiconductrice (15, 13s, $22_1$, 92s, 12s) dudit composant ($C_1$, $C_2$, $C_{10}$, $C_{20}$) de sorte à former avec la première portion semiconductrice au moins une jonction tunnel, en particulier de type NS (pour « Normal » « Supraconducteur ») ou NIS (pour « Normal » « Isolant » « Supraconducteur »).

2. Dispositif selon la revendication 1, le premier élément (51, 151, 951) de contact étant, de la première extrémité jusqu'à une deuxième extrémité, formée dudit matériau métallique supraconducteur (47) donné.

3. Dispositif selon la revendication 1, le premier élément (51, 151, 951) de contact comportant au niveau de la première extrémité un empilement d'une zone diélectrique (38,39) en contact avec la première portion semiconductrice et d'un tronçon (40, 48) à base dudit matériau métallique supraconducteur (47) donné.

4. Dispositif selon la revendication 3, dans lequel la zone diélectrique (38) est une zone oxydée du matériau semiconducteur de la première portion semi-conductrice.

5. Dispositif selon l'une quelconque des revendications précédentes, le premier élément de contact (51, 151, 951) comportant au niveau la première extrémité un empilement du matériau supraconducteur donné et d'un deuxième matériau supraconducteur (49) ayant un gap plus élevé que le matériau supraconducteur donné (47), le deuxième matériau supraconducteur (49) de gap plus élevé étant en contact avec la première portion semiconductrice.

6. Dispositif selon l'une des revendications précédentes, le matériau métallique supraconducteur donné (47) ayant une température critique Tc supérieure à 2K, avantageusement supérieure à 4K, tel que du TiN.

7. Dispositif selon l'une des revendications précédentes, dans lequel la zone de canal (12a, 92a) s'étend dans une première direction parallèle ou sensiblement parallèle à un plan principal du substrat et dans lequel le premier élément s'étend dans une direction orthogonale ou sensiblement orthogonale à la première direction, le premier élément (51, 151, 951) de contact étant relié par une deuxième extrémité à une piste métallique (101, 201, 1001) de matériau métallique supraconducteur parallèle ou sensiblement parallèle au plan principal du substrat.

8. Dispositif selon la revendication 7, dans lequel le premier élément (951) de contact est formé d'un ensemble de plots contacts (960) reliés en parallèle à la piste métallique (1001).

9. Dispositif selon l'une des revendications précédentes, le deuxième élément (52, 152, 952) de contact comprenant au moins un matériau métallique supraconducteur et étant en contact avec une deuxième portion semiconductrice dudit composant ($C_1$, $C_2$, $C_{10}$, $C_{20}$) de sorte à former avec la deuxième portion semiconductrice au moins une deuxième jonction tunnel NS ou NIS.

10. Dispositif selon l'une des revendications précédentes, le deuxième élément (52, 152, 952) de contact étant en contact avec une deuxième portion semi-conductrice dudit composant ($C_1$, $C_2$, $C_{10}$) et dans lequel la zone de canal s'étend entre une région semi-conductrice dite « de source » et une deuxième région semiconductrice dite « de drain », la première portion semiconductrice et la deuxième portion semi-conductrice étant chacune des portions de ladite région de source (13s) ou chacune des portions de ladite région de drain (13d).

11. Dispositif selon la revendication 10, dans lequel la structure (150) pour refroidir le composant comprend en outre un troisième élément (151) de contact en contact avec une troisième portion semiconductrice du composant et d'un quatrième élément (152) de contact avec une quatrième portion semiconductrice dudit composant, le troisième élément de contact formant une jonction tunnel, en particulier de type NIS ou NS avec la troisième portion semiconductrice du composant, la troisième portion semiconductrice et la quatrième portion semiconductrice étant chacune des portions d'une grille de contrôle électrostatique ($22_1$) dudit composant.

12

**12.** Dispositif selon l'une des revendications 1 à 8, le deuxième élément (52, 152, 952) de contact étant en contact avec une deuxième portion semiconductrice dudit composant ($C_1$, $C_2$, $C_{10}$, $C_{20}$) dans lequel la première portion semiconductrice et la deuxième portion semi-conductrice sont chacune des portions d'une grille ($22_1$) de contrôle électrostatique.

**13.** Dispositif selon l'une des revendications 1 à 8, dans lequel le deuxième élément (952) de contact étant en contact avec une deuxième portion semiconductrice dudit composant ($C_2$) dans lequel la zone « de canal » (92a) comporte un ou plusieurs ilots de détection pour lire l'état quantique d'une ou plusieurs boites quantiques d'une autre partie du composant ou d'un autre composant ($C_1$) et dans lequel la zone de canal s'étend entre une première région semiconductrice dite de source et une deuxième région semiconductrice dite « de drain », la première portion et la deuxième portion étant : respectivement une portion de la région de source et une portion de la région de drain.

**14.** Dispositif selon l'une des revendications 1 à 13, dans lequel le substrat comprend une cavité (172) agencée en regard dudit composant.

**15.** Dispositif électronique quantique selon l'une des revendications précédentes, dans lequel chaque ilot étant du composant ($C_1$, $C_2$, $C_{10}$) forme une boite quantique, le dispositif comprenant en outre : un autre composant ($C_{20}$) pour lire l'état quantique dudit composant ($C_1$, $C_2$, $C_{10}$), le dispositif comprenant en outre une structure (1500) prévue pour refroidir ledit autre composant ($C_{20}$) en faisant circuler un courant donné entre un élément (1052) de contact avec ledit autre composant ($C_{20}$) et un autre élément de contact avec ledit autre composant ($C_{20}$), lesdits éléments (1052, 1500) de contact formant au moins une jonction tunnel, en particulier de type NIS ou NS, avec une portion semiconductrice dudit autre composant ($C_{20}$).

**16.** Dispositif selon la revendication 15, dans lequel ledit composant ($C_{10}$) et ledit autre composant ($C_{20}$) sont reliés par un ligne métallique d'interconnexion (130) d'un niveau métallique d'interconnexions agencées dans au moins une couche isolante (127), la ligne métallique d'interconnexion étant entourée d'une cavité (171) formant un espace vide autour de la ligne métallique d'interconnexion et entouré par ladite couche isolante (127).

**17.** Procédé de fabrication d'un dispositif selon l'une des revendications 1 à 16, comprenant des étapes consistant à :

- prévoir le substrat (5) et ledit composant formé sur le substrat (5),
- dans au moins une couche isolante (25) recouvrant le composant réaliser au moins un premier trou (27a) et au moins un deuxième trou dévoilant respectivement la première portion semiconductrice et la deuxième portion semiconductrice dudit composant,
- former le premier élément (51) de contact dans le premier trou et le deuxième élément de contact dans le deuxième trou, en déposant au moins ledit matériau métallique supraconducteur (47) donné dans le premier trou et dans le deuxième trou.

FIG. 1

FIG. 2

FIG. 3

FIG. 4

FIG. 5

FIG. 6

FIG. 7

FIG. 8

FIG. 9

FIG. 10

FIG. 11

FIG. 12A

FIG. 12B

FIG. 12C

FIG. 12D

FIG. 12E

38                                                    38

FIG. 12F

47

FIG. 12G

51      38      47      151

FIG. 13

FIG. 14

FIG. 15

1620

1610

FIG. 16A

1620C — Cryo CMOS

1610C — Matrice qubits

Cryo CMOS — 1620B

1610A — Matrice qubits

Cryo CMOS

Matrice qubits — 1610B

1620A

FIG. 16B

FIG. 17

FIG. 18

FIG. 19

S I N I S

Chaleur   Chaleur

# FIG. 20

N  I $S_1$ $S_2$

Chaleur

# FIG. 21

Europäisches
Patentamt

European
Patent Office

Office européen
des brevets

# RAPPORT DE RECHERCHE EUROPEENNE

**Numéro de la demande**

EP 25 16 5139

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | PAZ B CARDOSO ET AL: "Coupling control in the few-electron regime of quantum dot arrays using 2-metal gate levels in CMOS technology", ESSCIRC 2022- IEEE 48TH EUROPEAN SOLID STATE CIRCUITS CONFERENCE (ESSCIRC), IEEE, 19 septembre 2022 (2022-09-19), pages 45-48, XP034211642, DOI: 10.1109/ESSCIRC55480.2022.9911381 * page 45, colonne de droite - page 48, colonne de droite; figures 1-12 * ----- | 1-17 | INV. H10N60/10 H01L23/34 H10N69/00 H10D30/40 H10D48/00 |
| Y | LAWRIE W I L ET AL: "Quantum dot arrays in silicon and germanium", APPLIED PHYSICS LETTERS, AMERICAN INSTITUTE OF PHYSICS, 2 HUNTINGTON QUADRANGLE, MELVILLE, NY 11747, vol. 116, no. 8, 24 février 2020 (2020-02-24), XP012244888, ISSN: 0003-6951, DOI: 10.1063/5.0002013 [extrait le 2020-02-24] * page 1, colonne de droite - page 7, colonne de gauche; figures 1-6 * ----- | 1-17 | |
| Y | US 2023/196152 A1 (LUETHI FLORIAN [US] ET AL) 22 juin 2023 (2023-06-22) * alinéa [0037] - alinéa [0091]; figures 1-12 * ----- | 1-17 | DOMAINES TECHNIQUES RECHERCHES (IPC) H10N H01L |
| Y | US 2023/299185 A1 (LUO JUNWEI [CN] ET AL) 21 septembre 2023 (2023-09-21) * alinéa [0056] - alinéa [0068]; figures 1a-6 * ----- | 1-17 | |
| Y | GB 2 520 030 A (UNIV WARWICK [GB]; VTT TECHNICAL RES CT OF FINLAND [FI]) 13 mai 2015 (2015-05-13) * page 7, ligne 21 - page 15, ligne 26; figures 1-9 * ----- | 1-17 | |

Le présent rapport a été établi pour toutes les revendications

| Lieu de la recherche | Date d'achèvement de la recherche | Examinateur |
|---|---|---|
| Munich | 11 juillet 2025 | Gröger, Andreas |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**　　　EP 25 16 5139

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

11-07-2025

| Document brevet cité au rapport de recherche | | Date de publication | Membre(s) de la famille de brevet(s) | | Date de publication |
|---|---|---|---|---|---|
| US 2023196152 | A1 | 22-06-2023 | CN | 116484958 A | 25-07-2023 |
| | | | EP | 4199106 A1 | 21-06-2023 |
| | | | US | 2023196152 A1 | 22-06-2023 |
| | | | US | 2024330726 A1 | 03-10-2024 |
| US 2023299185 | A1 | 21-09-2023 | EP | 4471832 A1 | 04-12-2024 |
| | | | US | 2023299185 A1 | 21-09-2023 |
| | | | WO | 2023141994 A1 | 03-08-2023 |
| GB 2520030 | A | 13-05-2015 | GB | 2520030 A | 13-05-2015 |
| | | | WO | 2015067933 A1 | 14-05-2015 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20220138609 A
- WO 2023156701 A1
- US 11302857 B2
- FR 2310911
- EP 3971983 A1
- EP 3971982 A1

**Littérature non-brevet citée dans la description**

- **JUHA T MUHONEN et al.** Micrometre-scale refrigerators. *Rep. Prog. Phys.*, 2012, vol. 75, 046501
- **T. BÉDÉCARRATS et al.** A new FDSOI spin qubit platform with 40nm effective control pitch. *IEEE International Electron Devices Meeting (IEDM)*, 2021